# EUROPEAN PATENT APPLICATION

(11) **EP 4 749 803 A1**
(43) Date of publication of application: **27.05.2026**
(21) Application number: 24214518.3
(22) Date of filing: 21.11.2024
(51) Int. Cl.: H01M 50/503, H01G 2/08

(54) **AN ELECTRIC SYSTEM HAVING BUSBARS ACTING AS COOLING ELEMENTS**

(71) Applicant: Skeleton Technologies GmbH, 04420 Markranstädt (DE)
(72) Inventor: Järveläinen, Tero, 11415 Tallinn (EE)
(74) Representative: Väänänen, Janne Kalervo

(57) **Abstract**

An electric system comprises electrical components (101b, 101d, 101e) such as capacitors and/or battery elements, and at least one busbar (102a, 102d) arranged to connect two or more of poles of the electrical components electrically to each other. The busbar is tubular to allow cooling medium, such as air or cooling liquid, to flow through the busbar. As the busbar is tubular, its inner surface and its outer surface can act as cooling surfaces of the busbar. Therefore, the cooling area of the busbar can be increased without excessively increasing the room needed by the busbar. Furthermore, the tubular one or more busbars may facilitate flow management of the cooling medium.

## Description

### Field

The invention relates to an electric system that comprises electrical components electrically connected to each other with one or more busbars which act as one or more cooling elements. The electrical components may comprise, for example, energy storage components such as capacitors and/or battery elements.

### Background

In many electric systems, there is a need to connect many electrical components electrically to each other with one or more busbars. The electrical system can be for example an energy storage where a plurality of capacitors and/or battery elements are electrically connected to each other with busbars. Publication CN221304925U describes a battery pack that comprises battery elements and a busbar arranged to connect poles of the battery elements electrically to each other. The busbar comprises a plate-shaped main body that is provided with a first connecting part and a second connecting part for providing galvanic contacts with the poles of the battery elements. Furthermore, the busbar comprises heat dissipation structure that has a heat conduction plate provided with a plurality of cooling fins. The heat dissipation structure is arranged in a direction away from the main body of the busbar, and one end of the heat conduction plate is connected to the main body. Therefore, the heat conduction plate is arranged to conduct heat from the main body of the busbar to the cooling fins, and thereby the heat dissipation performance of the busbar is improved.

An inconvenience related to electric systems where busbars are provided with heat dissipation structures of the kind mentioned above is that the heat dissipation structures provide a reasonable increase in cooling surfaces of the busbars only when a room needed by the heat dissipation structures is significant compared to a room needed by the main bodies of the busbars arranged to implement desired galvanic connections between electrical components. In some cases, it may be challenging to arrange a sufficient room for the heat dissipation structures of the busbars.

### Summary

The following presents a simplified summary to provide basic understanding of some aspects of various embodiments. The summary is not an extensive overview of the invention. It is neither intended to identify key or critical elements of the invention nor to delineate the scope of the invention. The following summary merely presents some concepts in a simplified form as a prelude to a more detailed description of exemplifying and non-limiting embodiments.

In this document, the word "geometric" when used as a prefix means a geometric concept that is not necessarily a part of any physical object. The geometric concept can be for example a geometric point, a straight or curved geometric line, a geometric plane, a non-planar geometric surface, a geometric space, or any other geometric entity that is zero, one, two, or three dimensional.

In accordance with the invention, there is provided a new electric system that comprises:
- electrical components, e.g. energy storage components such as capacitors and/or battery elements, and
- at least one busbar arranged to connect two or more of poles of the electrical components electrically to each other, the busbar being tubular to allow cooling medium to flow through the busbar.

As the busbar is tubular, it has an inner surface and an outer surface which can act as cooling surfaces of the busbar. Therefore, the cooling area of the busbar can be increased without excessively increasing the room needed by the busbar. Furthermore, in many cases, the tubular busbar or busbars facilitate flow management of the cooling medium, e.g. gas or liquid. The flow can be a forced flow, or the flow can be based on natural convection.

In an electric system according to an exemplifying and non-limiting embodiment, the inner surface and/or the outer surface of the busbar is provided with cooling fins to further increase the cooling area of the busbar.

Exemplifying and non-limiting embodiments are described in accompanied dependent claims.

Various exemplifying and non-limiting embodiments both as to constructions and to methods of operation, together with additional objects and advantages thereof, will be best understood from the following description of specific exemplifying and non-limiting embodiments when read in conjunction with the accompanying drawings.

The verbs "to comprise" and "to include" are used in this document as open limitations that neither exclude nor require the existence of unrecited features.

The features recited in dependent claims are mutually freely combinable unless otherwise explicitly stated.

Furthermore, it is to be understood that the use of "a" or "an", i.e. a singular form, throughout this document does not exclude a plurality.

### Brief description of the figures

Exemplifying and non-limiting embodiments and their advantages are explained in greater detail below in the sense of examples and with reference to the accompanying drawings, in which:
Figures 1a and 1b illustrate a part of an electric system according to an exemplifying and non-limiting embodiment, and
Figures 2a and 2b illustrate an electric system according to an exemplifying and non-limiting embodiment.

### Description of the exemplifying embodiments

The specific examples provided in the description given below should not be construed as limiting the scope and/or the applicability of the invention. Lists and groups of examples provided in the description given below are not exhaustive unless otherwise explicitly stated.

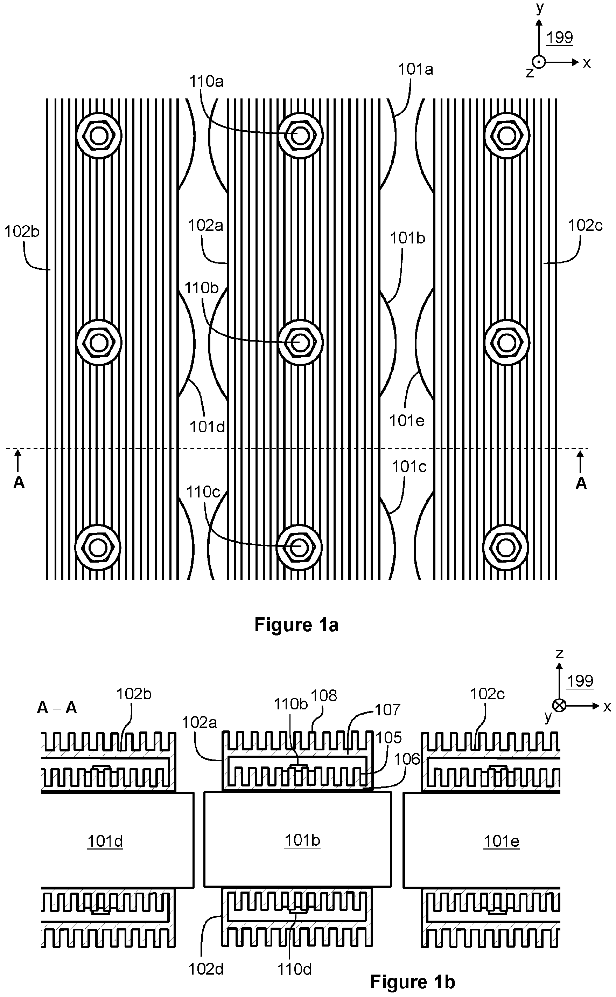

Figures 1a and 1b illustrate a part of an electric system according to an exemplifying and non-limiting embodiment. Figure 1b shows a section taken along a geometric line A-A shown in figure 1a. The geometric section plane is parallel with the geometric xz-plane of a coordinate system 199. The electric system comprises electrical components and busbars arranged to connect poles of the electrical components electrically to each other. In figures 1a and 1b, five of the electrical components are denoted with references 101a, 101b, 101c, 101d, and 101e, and four of the busbars are denoted with references 102a, 102b, 102c, and 102d. In figure 1a, poles of the electrical components 101a-101c which are electrically connected to each other with the busbar 102a are denoted with references 110a, 110b, and 110c. In figure 1b, the poles of the electrical component 101b are denoted with the reference 110b and a reference 110d.

The electrical components may comprise, for example, energy storage components such as capacitors and/or battery elements. The electric system can be for example an array of capacitors so that the capacitors are arranged to constitute groups of capacitors connected in parallel with the busbars and the groups can be connected in parallel, in series, or in some other way to each other. Each capacitor can be e.g. a foil capacitor, an electrolytic capacitor, or a super-capacitor such as electric double layer capacitor "EDLC" or a carbon capacitor. In electric systems according to embodiments of the invention, the electrical components do not need to be like each other, but it is also possible that electrical components different from each other, e.g. capacitors, battery elements, inductor coils, resistors, semiconductors such as diodes, and/or other electrical components are electrically connected to each other with busbars.

Each of the above-mentioned busbars 102a-102d is tubular to allow cooling medium to flow through the busbar. Thus, each of the busbars 102a-102d has an inner surface and an outer surface which can act as cooling surfaces of the busbar. The cooling medium can be gas, e.g. air, or liquid. The liquid can be e.g. transformer oil or, in cases where a liquid circulation system does not comprise busbars at different electrical potentials, the liquid can be water. The cooling via the busbars is advantageous in conjunction with electric components, e.g. capacitors, which are advantageously cooled via their electrical poles.

In the exemplifying electric system illustrated in figures 1a and 1b, each of the busbars 102a-102d has a rectangular cross-section so that a first wall attached to poles of the electrical components and a second wall parallel with the first wall are wider than third and fourth walls constituting side walls of the busbar. In figure 1b, the first and second walls of the busbar 102a are denoted with references 106 and 107. In this exemplifying case, the inner surface of the first wall is provided with cooling fins and the outer surface of the second wall is provided with cooling fins. In figure 1b, one of the cooling fins on the inner surface of the wall 106 is denoted with a reference 105, and one of the cooling fins on the outer surface of the wall 107 is denoted with a reference 108.

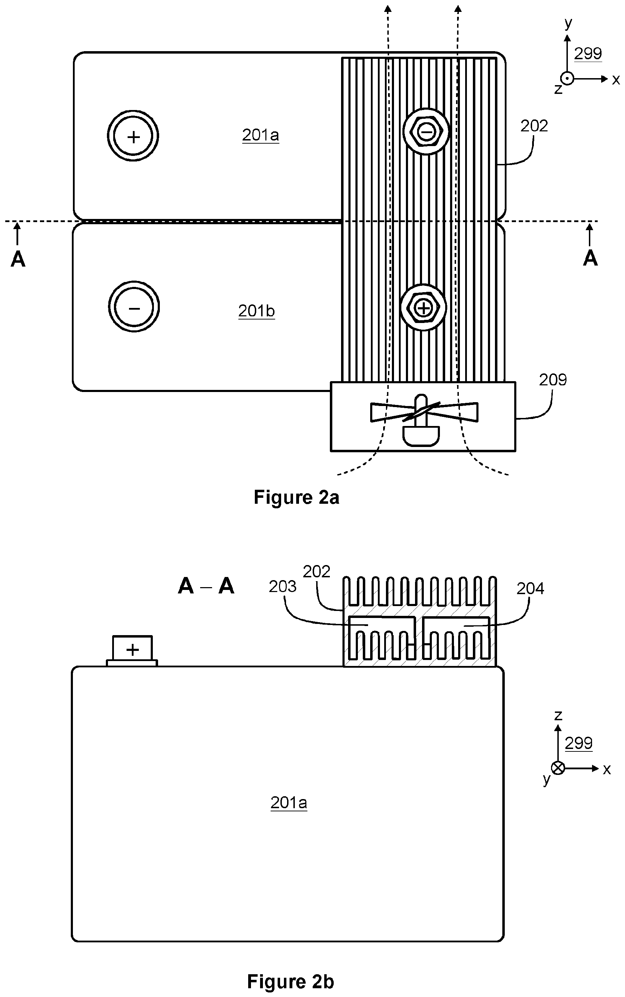

Figures 2a and 2b illustrate an electric system according to an exemplifying and non-limiting embodiment. Figure 2b shows a section taken along a geometric line A-A shown in figure 2a. The geometric section plane is parallel with the geometric xz-plane of a coordinate system 299. The electric system comprises electrical components 201a and 201b and a busbar 202 arranged to connect poles of the electrical components electrically to each other. In this exemplifying case, the electrical components 201a and 201b are battery elements which are electrically connected in series with the aid of the busbar 202.

The above-mentioned busbar 202 is tubular so that the busbar 202 has parallel channels 203 and 204 for conducting cooling medium, i.e. liquid or gas. It is also possible that a busbar has more than two parallel channels, e.g. three or four parallel channels, for conducting the cooling medium. The walls between the parallel channels increase the cooling surface of the busbar in the same way as cooling fins. As shown in figure 2b, the busbar 202 also has cooling fins on its inner surface and on its outer surface. In this exemplifying case, the cooling medium is air, and the electric system comprises a motored device 208 configured to drive the cooling air to flow through the busbar 202. In this case, the motored device 208 is blower. In figure 2a, the flow of the cooling air is depicted with dashed line arrows. In an electric system according to an exemplifying and non-limiting embodiment where cooling liquid is circulated through one or more busbars, a corresponding motored device is a pump. It is however also possible to utilize natural convection for moving cooling medium that can be gas or liquid, so that one or more tubular busbars are vertical or at least obliquely positioned with respect to the horizontal direction.

The specific examples provided in the description given above should not be construed as limiting the applicability and/or the interpretation of the invention. Lists and groups of examples provided in the description given above are not exhaustive unless otherwise explicitly stated.

## Claims

1. An electric system comprising:
- electrical components (101a-101e, 201a, 201b), and
- at least one busbar (102a-102d, 202) arranged to connect two or more of poles (110a-110d) of the electrical components electrically to each other,
**characterized in that** the busbar is tubular to allow cooling medium to flow through the busbar.

2. An electric system according to claim 1, wherein the busbar (202) has two or more parallel channels (203, 204) to conduct the cooling medium.

3. An electric system according to claim 1 or 2, wherein an inner surface of the busbar is provided with cooling fins (105).

4. An electric system according to according to any one of claims 1-3, wherein an outer surface of the busbar is provided with cooling fins (108).

5. An electric system according to any one of claims 1-4, wherein a cross-section of the busbar (102a-102c, 202) is rectangular so that a first wall (106) attached to the two or more of poles of the electrical components (101b) and a second wall (107) parallel with the first wall are wider than third and fourth walls constituting side walls of the busbar.

6. An electric system according to claim 5, wherein an inner surface of the first wall is provided with cooling fins (105).

7. An electric system according to claim 5 or 6, wherein an outer surface of the second wall is provided with cooling fins (108).

8. An electric system according to any one of claims 1-7, wherein the electrical components (101a-101e, 201a, 201b) comprise energy storage components.

9. An electric system according to claim 8, wherein the energy storage components comprise one or more capacitors.

10. An electric system according to claim 9, wherein the one or more capacitors comprise one or more electric double layer capacitors.

11. An electric system according to claim 9 or 10, wherein the one or more capacitors comprise one or more carbon capacitors.

12. An electric system according to any one of claims 8-11, wherein the energy storage components (201a, 201b) comprise one or more battery elements.

13. An electric system according to claim 8, wherein the energy storage components comprise one or more battery elements and one or more capacitors.

14. An electric system according to any one of claims 1-13, wherein the electric system comprises a motored device (209) configured to drive the cooling medium to flow through the busbar.

15. An electric system according to any one of claims 1-13, wherein the at least one busbar is vertical or obliquely positioned with respect to a horizontal direction to utilize natural convection for moving the cooling medium through the busbar.

## Amended claims

### Amended claims in accordance with Rule 137(2) EPC.

1. An electric system comprising:
- electrical components (101a-101e, 201a, 201b), and
- at least one busbar (102a-102d, 202) arranged to connect two or more of poles (110a-110d) of the electrical components electrically to each other,
wherein the busbar is tubular to allow cooling medium to flow through the busbar, **characterized in that** an inner surface of the busbar is provided with cooling fins (105).

2. An electric system according to claim 1, wherein the busbar (202) has two or more parallel channels (203, 204) to conduct the cooling medium.

3. An electric system according to according to claim 1 or 2, wherein an outer surface of the busbar is provided with cooling fins (108).

4. An electric system according to any one of claims 1-3, wherein a cross-section of the busbar (102a-102c, 202) is rectangular so that a first wall (106) attached to the two or more of poles of the electrical components (101b) and a second wall (107) parallel with the first wall are wider than third and fourth walls constituting side walls of the busbar.

5. An electric system according to claim 4, wherein an inner surface of the first wall is provided with cooling fins (105).

6. An electric system according to claim 4 or 5, wherein an outer surface of the second wall is provided with cooling fins (108).

7. An electric system according to any one of claims 1-6, wherein the electrical components (101a-101e, 201a, 201b) comprise energy storage components.

8. An electric system according to claim 7, wherein the energy storage components comprise one or more capacitors.

9. An electric system according to claim 8, wherein the one or more capacitors comprise one or more electric double layer capacitors.

10. An electric system according to claim 8 or 9, wherein the one or more capacitors comprise one or more carbon capacitors.

11. An electric system according to any one of claims 7-10, wherein the energy storage components (201a, 201b) comprise one or more battery elements.

12. An electric system according to claim 7, wherein the energy storage components comprise one or more battery elements and one or more capacitors.

13. An electric system according to any one of claims 1-12, wherein the electric system comprises a motored device (209) configured to drive the cooling medium to flow through the busbar.

14. An electric system according to any one of claims 1-12, wherein the at least one busbar is vertical or obliquely positioned with respect to a horizontal direction to utilize natural convection for moving the cooling medium through the busbar.
